(19) **Europäisches Patentamt**

**European Patent Office**

**Office européen des brevets**

(11) **EP 0 700 524 B1**

(12) **EUROPÄISCHE PATENTSCHRIFT**

(45) Veröffentlichungstag und Bekanntmachung des Hinweises auf die Patenterteilung:
**12.01.2000 Patentblatt 2000/02**

(51) Int Cl.$^7$: **G01P 15/08**

(21) Anmeldenummer: **94915017.1**

(86) Internationale Anmeldenummer:
**PCT/DE94/00538**

(22) Anmeldetag: **11.05.1994**

(87) Internationale Veröffentlichungsnummer:
**WO 94/28426 (08.12.1994 Gazette 1994/27)**

(54) **VERFAHREN ZUR HERSTELLUNG OBERFLÄCHEN-MIKROMECHANISCHER STRUKTUREN**

PROCESS FOR PRODUCING SURFACE MICROMECHANICAL STRUCTURES

PROCEDE PERMETTANT DE REALISER DES STRUCTURES A SURFACE MICROMECANIQUE

(84) Benannte Vertragsstaaten:
**CH DE FR GB LI**

(30) Priorität: **25.05.1993 DE 4317274**

(43) Veröffentlichungstag der Anmeldung:
**13.03.1996 Patentblatt 1996/11**

(73) Patentinhaber: **ROBERT BOSCH GMBH**
**70442 Stuttgart (DE)**

(72) Erfinder: **OFFENBERG, Michael**
**D-72076 Tübingen (DE)**

(74) Vertreter: **Wiechmann, Manfred, Dipl.-Ing. et al**
**Robert Bosch GmbH**
**Patentabteilung**
**Postfach 30 02 20**
**70442 Stuttgart (DE)**

(56) Entgegenhaltungen:
**EP-A- 0 456 029**

- **SOLID STATE SENSOR AND ACTUATOR WORKSHOP.TECHNICAL DIGEST (CAT.NO. 88TH0215-4),6.-9.JUNI 1988, HILTON HEAD ISLAND,SC,USA Seiten 59 - 62 T.LOBER 'Surface-micromachining Processes for Electrostatic Microactuator Fabrication'**
- **IEEE PROCEEDINGS MICRO ELECTRO MECHANICAL SYTEMS (CAT.NO.93CH3265-6), 7.-10. FEBRUAR 1993, FORT LAUDERDALE,FL,USA Seiten 77 - 81, XP366859 C.H.MASTRANGELO 'A Dry-release Method Based on Polymer Columns for Microstructure Fabrication'**

**Beschreibung**

Stand der Technik

Die Erfindung betrifft ein Verfahren zur Herstellung oberflächen-mikromechanischer Strukturen gemäß dem Oberbegriff des Hauptanspruchs.

Aus der Druckschrift WO 92/03740 ist ein Verfahren zur Herstellung oberflächen-mikromechanischer Strukturen bekannt, wobei auf ein Siliziumsubstrat als Siliziumwafer eine Opferschicht aus Siliziumoxid deponiert und so strukturiert wird, daß u.a. Fenster zum Siliziumsubstrat als spätere Verankerungsstellen für freie Strukturen geschaffen werden. Auf der Opferschicht wird eine zweite Schicht aus Polysilizium abgeschieden und ebenfalls strukturiert entsprechend der lateralen Begrenzungen der späteren freien Strukturen.

Anschließend wird mit wässriger Flußsäurelösung als Ätzlösung, die eine hohe Selektivität gegenüber polykristallinem Silizium und damit gegenüber der zweiten Schicht aufweist, die Opferschicht entfernt. Dadurch entstehen Strukturen, die im Abstand der Dicke der entfernten Opferschicht frei über dem Siliziumsubstrat stehen und an den vorher strukturierten Fensterstellen der Opferschicht auf dem Siliziumsubstrat verankert sind.

Nach dem Ätzen wird der Siliziumwafer gespült, wobei die Spülflüssigkeit anschließend vom Wafer und den mikromechanischen Strukturen wieder entfernt werden muß. Ein an sich übliches Trocknen durch Schleudern oder Heizen ist jedoch hier nicht möglich, da die sich zurückziehenden Flüssigkeiten durch ihre Oberflächenspannung Kräfte auf die freigeätzten Mikrostrukturen ausüben würden. Dadurch würden die flexiblen, freigelegten Mikrostrukturen deformiert werden, sich an das Siliziumsubstrat anlegen und damit irreversibel auf der Substratoberfläche haften bleiben. Es ist daher bekannt, die Spülflüssigkeit durch eine Flüssigkeit auszutauschen, die entweder durch Einfrieren (z.B. Cyclohexan) oder durch Lösemittelentzug (Fotolack/Azetongemisch) in die feste Phase überführt werden kann. Anschließend erfolgt durch Sublimation oder durch chemische Reaktion, z.B. durch den bekannten Fotolack/Azeton-Veraschungsprozeß der Übergang vom festen in den gasförmigen Zustand, bei dem nur minimale Kräfte durch Oberflächenspannungen auftreten und dadurch die mikromechanischen Strukturen frei bleiben.

Aus einem Artikel von T.Lober et al. in Solid State Sensor and Actuator Workshop, (Cat. No. 88tho215-4), 6. - 9- Juni 1988, Hilton Head Island, ist bereits ein Verfahren zum Ätzen von Opferschichten bekannt, bei dem gasförmige Flußsäure (VHF) verwendet wird. Auf der Seite 61 wird beschrieben, daß bei der Ätzung mit VHF durch sich bildendes Kondensat Kapillarkräfte auf die feinen mikromechanischen Strukturen wirken können, die ein Festkleben der Strukturen bewirken. Um dies zu verhindern, wird eine gute Belüftung der geätzten Struktur vorgeschlagen.

In einem Artikel von Mastrangelo (IEEE Porceedings Micro Electro Mechanical Systems Cat. No. 93CH3265-6, Feb. 1993, Fort Lauterdale USA) wird ein Ätzverfahren vorgeschlagen, bei dem eine Opferschicht durch flüssige Flußsäure entfernt wird. Bei diesem Ätzschritt wird die eigentliche Mikrostruktur durch temporäre Stützstrukturen unterstützt.

Aus der EP 456 029 Al ist ein Verfahren zur Ätzung von Opferschichtstrukturen durch Eintauchen in flüssige Flußsäure bekannt.

Vorteile der Erfindung

Bei dem gattungsgemäßen Herstellungsverfahren mit den kennzeichnenden Merkmalen des Hauptanspruchs wird zum Ätzen und zur Freilegung der mikromechanischen Strukturen der Siliziumwafer in keine Ätzflüssigkeit getaucht und braucht daher auch nicht aufwendig getrocknet zu werden. Der Siliziumwafer wird dagegen der Dampfphase eines Gemisches aus anhydrider Flußsäure und Wasser in einer Dampfphasenätzung ausgesetzt, wobei durch geeignete Maßnahmen, z.B. durch Heizen des Wafers, sicherzustellen ist, daß sich kein Kondensat auf der Waferoberfläche bildet, welches die frei werdenden mikromechanischen Strukturen anhaften läßt. Obwohl Wasser in der Ätzreaktion ein Produkt ist, ist es auch als Initiator notwendig, da bei der Entfernung von Siliziumoxid die Reaktion über Zwischenschritte nach der Reaktionsgleichung erfolgt:

$$SiO_2 + 4\ HF \rightarrow SiF_4 + 4\ H_2O$$

Vorteilhaft läßt sich daher durch Einstellen des Wassergehalts an der Waferoberfläche die Reaktionsgeschwindigkeit steuern und der Ätzvorgang kontrollieren. Neben dem aus der Dampfphase stammenden Wasser beeinflußt die Menge des vor der Ätzung absorbierten bzw. adsorbierten Wassers die Ätzrate. Es sind kurze Ätzzeiten von nur wenigen Stunden möglich und nach einer Dampfphasenätzung sind die mikromechanischen Strukturen frei und trocken. Zeitaufwendige Sublimationen und Spülen mit bis zu mehreren Tagen Dauer, wie sie beim herkömmlichen Verfahren anfallen, sind nicht erforderlich. Durch die geringen Krafteinwirkungen bei der Dampfphasenätzung auf die Strukturen sind auch sehr empfindliche Strukturen realisierbar. Die Dampfphasenätzung läßt sich an verschiedenen Stellen der IC-Herstellung durchführen und erleichtert damit die Verwendung von Standardtechniken und die Integrierbarkeit von Auswerteelektronik. Zudem kann das Verfahren mit einfachen Mitteln durchgeführt und auf bestehende Prozesse übertragen werden.

Die Unteransprüche haben vorteilhafte Weiterbildungen des Herstellungsverfahrens nach dem Hauptanspruch zum Inhalt. Insbesondere kann vorteilhaft eine Opferschicht aus undotiertem Siliziumoxid direkt mit der Dampfphasenätzung entfernt werden. Es sind zudem mechanische Verstärkungen zwischen dem Siliziumsubstrat und den freizuätzenden Strukturen möglich, die erst zum Ende des Prozesses entfernt werden. Es können auch Opferschichten aus dotieretem Siliziumoxid in einem ersten herkömmlichen Ätzvorgang mit flüssiger Ätzlösung entfernt und eine Spülflüssigkeit durch Schleudern entfernt werden, wobei anschließend durch einen zweiten Ätzvorgang in der trockenen Dampfphasenätzung Verstärkungen entfernt werden. Zum Schutz der mikromechanischen Strukturen, insbesondere bei der Vereinzelung, sind in einfacher Weise auch verkapselte Anordnungen ausführbar. Die Opferschichtentfernung mit einer Dampfphasenätzung erfordert keine Prozeßschritte auf Waferebene und kann auch nach der Vereinzelung auf Chipebene durchgeführt werden. Bei einer azeotropen Konzentration der Flußsäure von 38,26 % entspricht das Verhältnis Flußsäure/Wasser in der flüssigen Phase dem in der Gasphase, so daß konstante Ätzbedingungen über der Zeit erhalten werden.

Besonders vorteilhaft kann mit Hilfe einer Teststruktur und einer Kapazitätsmessung eine In-Situ-Ätzratenkontrolle durchgeführt werden, da hier das Ätzmedium elektrisch nicht leitet.

Zeichnung

Ausführungsbeispiele der Erfindung sind in der Zeichnung dargestellt und in der nachfolgenden Beschreibung näher erläutert.

Fig. 1    zeigt schematisch einen Schnitt durch ein Gefäß, das teilweise mit anhydrider Flußsäure und Wasser gefüllt ist und auf das ein Siliziumwafer aufgelegt ist,

Fig. 2    eine perspektivische Draufsicht auf eine relativ große, mikromechanische Struktur eines Beschleunigungssensors mit aufgebrachten, mechanischen Verstärkungen,

Fig. 3    eine Draufsicht auf eine Ausführung, ähnlich Fig. 2, mit einer Kapselung,

Fig. 4    eine Draufsicht auf eine Teststruktur zu einer In-Situ-Ätzratenkontrolle und

Fig. 5    ein Diagramm zur Veränderung der Kapazität in der Anordnung nach Fig. 4.

Beschreibung von Ausführungsbeispielen

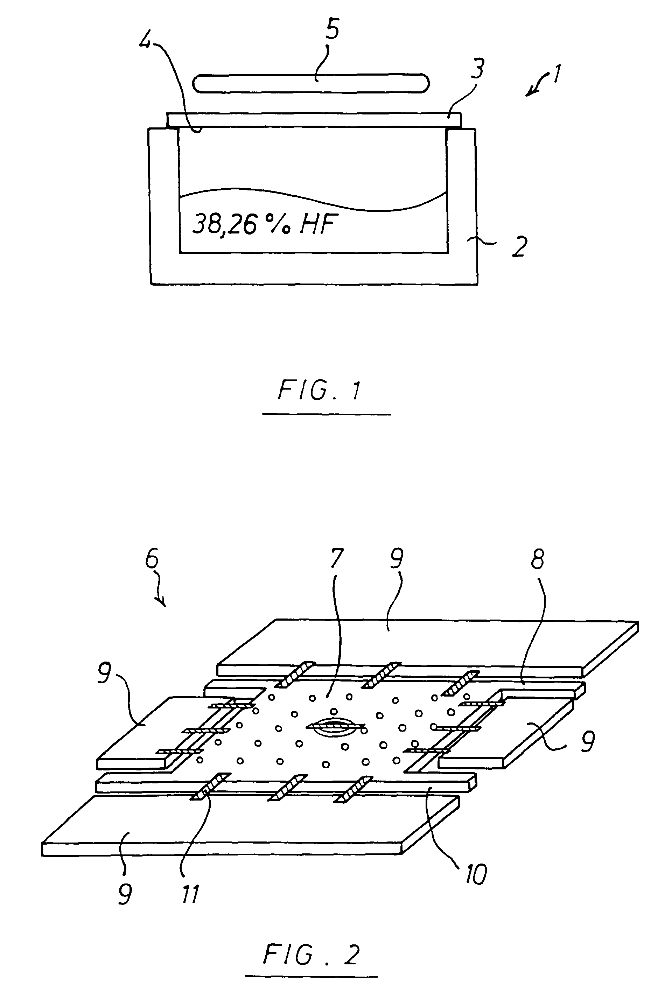

In Fig. 1 ist eine Anordnung 1 zu einer Dampfphasenätzung dargestellt, mit einem Behälter 2, die eine Flußsäurelösung HF mit einer azeotropischen Konzentration von 38,26 % enthält. Auf den Behälter ist ein Siliziumwafer 3 dicht aufgesetzt, so daß die Oberfläche 4, auf der mikromechanische Strukturen hergestellt werden, der Behälterinnenseite zugewandt und damit der Dampfphase aus anhydrider Flußsäure und Wasser ausgesetzt ist. Der Siliziumwafer 3 kann eine Vielzahl von Siliziumsubstraten 9 aufweisen.

Über dem Wafer 3 ist eine flächige Heizung 5 zu dessen Beheizung angeordnet. Neben einer Heizung kann eine Kondensation eines Wasserfilms auch durch ein Pumpen verhindert werden.

Der Siliziumwafer 3 ist vor der Dampfphasenätzung in der Anordnung gemäß Fig. 1 so aufgebaut, daß auf einem Siliziumsubstrat eine Opferschicht aus Siliziumoxid mit Fenstern für spätere Verankerungen der Strukturelemente deponiert ist. Auf der Opferschicht ist eine zweite Schicht aus Polysilizium abgeschieden und entsprechend der lateralen Begrenzungen der Strukturelemente strukturiert.

In der Anordnung gemäß Fig. 1 wird durch die Dampfphasenätzung die Opferschicht trocken entfernt, so daß freistehende Strukturelemente im Abstand der Dicke der Opferschicht frei über dem Substrat stehen.

Durch kontrollierte Beheizung des Siliziumwafers 3 mit dem Heizelement 5 wird der Wassergehalt an der Waferoberfläche 4 eingestellt, wodurch die Ätzrate steuerbar ist. Bei einer undotierten Opferschicht aus Siliziumoxid kann mit dieser Anordnung und mit diesem Verfahren die Opferschicht direkt entfernt werden, wobei nur minimale Kräfte auf die freigelegten Strukturen auftreten.

Da bei der Realisierung von oberflächen-mikromechanischen Strukturen und Sensoren oft auch elektronische Schaltungen, insbesondere in der Art von Auswerteschaltungen, integriert werden, müssen diese durch einen geeigneten IC-kompatiblen Schutzfilm vor dem Ätzmedium geschützt werden. Bei herkömmlichen Ätzungen in flüssigen Ätzmedien zeigen Fotolacke die Tendenz, aufzuquellen und sich bereits nach kurzer Zeit abzulösen, lange bevor der Ätzvorgang abgeschlossen ist, so daß die Schutzwirkung entfällt. Bei der vorliegenden Dampfphasenätzung zeigt dagegen gewöhnlicher Positivlack eine sehr gute Resistenz gegen das Ätzmedium und stellt damit während des gesamten Ätzvorgangs einen wirksamen Schutz für integrierte Schaltungen dar. Nach der Dampfphasenätzung wird der Fotolack mit Sauerstoffplasma entfernt.

In Fig. 2 ist eine relativ große freizulegende Struktur 6 als Meßelement eines Beschleunigungssensors dargestellt. Die Struktur 6 besteht im wesentlichen aus einer Masse als Platte 7, die an den Ecken über vier Schenkel 8 mit dem Siliziumsubstrat 9 als Träger verbunden und dadurch mechanisch sehr weich aufgehängt sind. Im gezeigten Zustand ist die Platte 7 mit ihren Schenkeln 8 über Ätzgräben 10 in ihrer lateralen Begrenzung freigeätzt. Mit der nun folgenden Dampfphasenätzung entsprechend Fig. 1 soll die (nicht explizit dargestellte) Opferschicht aus Siliziumoxid unter der Platte 7 entfernt werden.

Wegen der mechanisch sehr weichen Aufhängung können bereits geringste Kräfte beim Freiätzen eine Auslenkung der Masse bzw. Platte 7 bewirken und zu einem irreversiblen Anhaften führen. Um dem entgegenzuwirken, sind vor der Dampfphasenätzung Versteifungen aus Fotolack zwischen der freizulegenden Struktur bzw. Platte 7 und dem Träger aus Siliziumsubstrat 9 angebracht. Diese Versteifungen 11 können am Rand oder auch in der Mitte der jeweiligen Masse in beliebiger Zahl angebracht werden und verhindern eine Auslenkung und damit ein Anhaften während des Ätzvorgangs. Dabei wird die Ätzresistenz von Fotolacken bezüglich des verwendeten Ätzmediums ausgenutzt, so daß die jeweilige Masse bzw. Platte 7 mit temporären Versteifungen versehen ist.

Diese Versteifungen aus Fotolack werden zweckmäßig zugleich mit einem Fotolack-Schutzfilm für elektronische Schaltungen aufgebracht. Nach dem Freiätzen wird der Fotolack, d.h. gegebenenfalls ein Schutzfilm und die Versteifungen, mit Sauerstoffplasma entfernt, wodurch die Strukturen freigegeben werden.

Mit dem beschriebenen Verfahren kann eine Opferschicht aus undotiertem Siliziumoxid vollständig entfernt werden. Bei einem Druck im mtorr-Bereich ist dieses Verfahren auch zur Ätzung von PSG (Phosphor-Silikat-Gläsern) geeignet. Es werden jedoch auch dotierte Oxide (Bor- oder Phosphorsilicatglas) oder Silizium-Nitride für Opferschichten eingesetzt. Bei der Ätzung in flüssigen Medien lassen sich solche dotierte Opferschichten rückstandsfrei ätzen. Bei der erfindungsgemäßen Dampfphasenätzung reichern sich jedoch Bestandteile der Opferschichten, z.B. Dotierstoffe, auf der Siliziumsubstratoberfläche an und hinterlassen Filme bzw. Partikel, die zwar wasserlöslich sind, aber im vorliegenden, trockenen Verfahren nicht entfernt werden können, ohne dessen Vorteile aufzugeben. Damit ist eine Ätzung dieser dotierten Opferschichten in der Dampfphase praktisch nicht durchführbar. Es sind aber dennoch die Vorteile des erfindungsgemäßen Verfahrens auch hier nutzbar. Dazu werden ebenfalls Versteifungen 11 an der Struktur 6 angebracht, wie sie beispielsweise in Fig. 2 dargestellt sind. Diese Versteifungen sind hier aus einem, gegenüber der zu entfernenden Opferschicht, langsam ätzenden Material hergestellt. Zum Freiätzen der Strukturen wird eine Zweistufenätzung durchgeführt: Zunächst wird nach den bekannten Verfahren in einer Ätzflüssigkeit die Opferschicht rückstandsfrei entfernt. Dabei bleiben die langsamer ätzenden Versteifungen 11 noch weitgehend erhalten, wodurch die freizulegende Struktur bzw. Platte 7 an einer Auslenkung gehindert ist und nicht anhaften kann. Durch die Festlegung und Fixierung über die Versteifungen 11 kann auf die Strukturen ohne negative Auswirkung eine relativ große Kraft einwirken, so daß eine Trocknung des Siliziumwafers durch einfaches Schleudern möglich ist. Aufwendige Sublimationsverfahren oder chemische Verfahren zur Trocknung können entfallen. Im Anschluß daran werden die Versteifungen 11 in einer erfindungsgemäßen, trockenen Dampfphasenätzung entfernt und die Strukturen liegen damit frei.

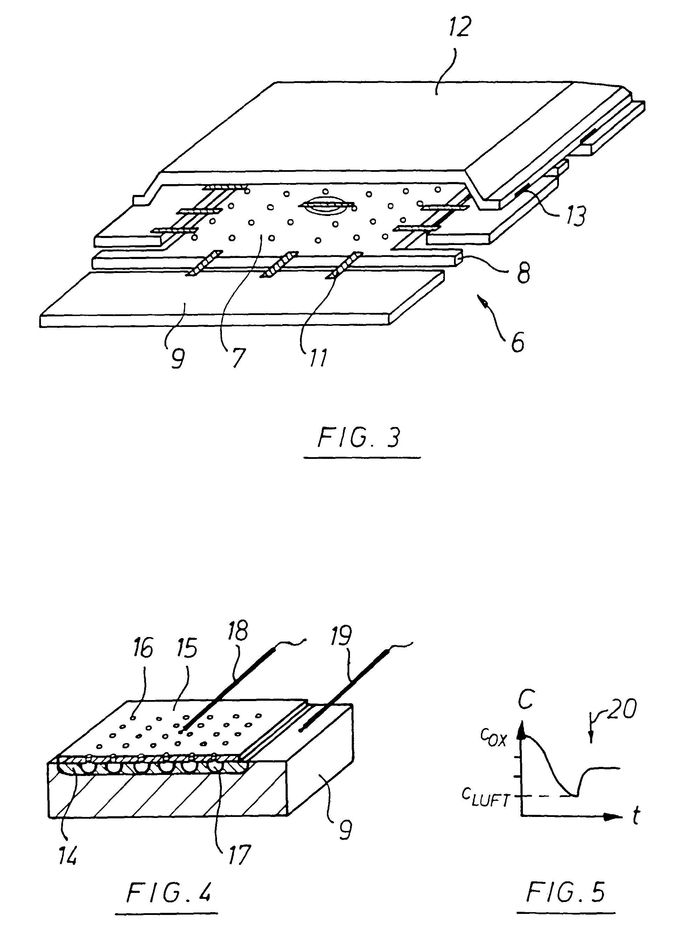

In Fig. 3 ist ein ähnlicher Aufbau einer Struktur 6 dargestellt wie in Fig. 2, so daß für gleiche Teile gleiche Bezugszeichen verwendet sind. Auch hier ist eine Masse als Platte 7 eines Beschleunigungssensors über Schenkel 8 relativ weich an einem umgebenden Siliziumsubstrat 9 aufgehängt, wobei vor der Dampfphasenätzung der Opferschicht unter der Platte 7 Versteifungen 11 als Brücken angebracht sind. Zudem ist die Struktur 6 durch eine Abdeckung 12 aus Polysilizium gekapselt. An den seitlichen Aufstandsflächen der Abdeckung 12 sind Ätzöffnungen 13 als Durchgänge zur Struktur 6 angebracht.

Für die Versteifungen 11 kann bei dieser verkapselten Ausführungsform kein Fotolack verwendet werden, da über diesem aus Temperaturgründen keine zweite Polysiliziumschicht als Abdeckung 2 deponiert werden kann. Es wird daher anstelle von Fotolack ein in der Dampfphasenätzung langsam und rückstandsfrei ätzendes Material verwendet, das zu LPCVD-Depositionen (Low Pressure Chemical Vapor Deposition) kompatibel ist. Auch dieses Material dient zur temporären Versteifung und ätzt langsamer als das Material der Opferschicht. Als geeignetes Material für diese temporären Versteigungen 11 kommt hier eine dünne Polysiliziumschicht in Frage, deren Ätzselektivität gegenüber dem Siliziumoxid der Opferschicht durch Sauerstoffimplantation gezielt eingestellt werden kann.

Zum Freiätzen dringt das Ätzmedium durch die Ätzöffnungen 13 zur Struktur 6 in den geschaffenen Innenraum ein. In einem ersten Ätzabschnitt wird zunächst die Opferschicht vollständig entfernt, wobei die Versteifungen 11 nur zum Teil angegriffen werden und ihre Abstützfunktion weiter behalten, so daß die freizulegende Masse bzw. Platte 7 in ihrer Stellung fixiert ist und ein Anhaften auf den Träger verhindert wird. In einem zweiten Ätzabschnitt werden dann die Versteifungen 11 durch Weiterätzen entfernt, wodurch die Struktur bzw. Platte 7 freigegeben wird. Danach läßt sich die Kammeranordnung durch Deposition einer weiteren Schicht verschließen und der Wafer weiterbearbeiten bzw. vereinzeln. Eine gekapselte Anordnung ist bei der Vereinzelung des Wafers auf einer Standardsäge vorteilhaft, da dann kein Sägeschlamm und Kühlflüssigkeit unter die freigelegten Strukturen gelangen kann.

Eine andere Möglichkeit, diese Probleme beim Sägen und vereinzeln mikromechanischer Elemente zu umgehen, liegt in der Vertauschung der sonst üblichen Abfolge von Opferschichtätzen und Sägen. Da das erfindungsgemäße Verfahren mit Dampfphasenätzung im Gegensatz zu den bekannten Verfahren mit Flüssigkeitsätzung keine Prozeßschritte auf Waferebene erfordert, kann die Opferschichtätzung auch nach der Vereinzelung auf Chipebene durchgeführt werden. Die Vereinzelung wird zweckmäßig auf einer Sägefolie mit adhäsiver Beschichtung vorgenommen. Zum Schutz der strukturierten, aber noch nicht freigelegten, mikromechanischen Strukturen, kann die Oberfläche durch eine Spezialfolie vor dem Sägeschlamm geschützt werden. Nach dem Entfernen der oberen Folie werden die vereinzelten Chips auf der Sägefolie dem Ätzmedium in der Dampfphasenätzung ausgesetzt und die Opferschicht entfernt. Gegebenenfalls vorhandene, integrierte Schaltungen werden auch hierbei durch Fotolack geschützt.

In Fig. 4 ist eine Teststruktur dargestellt, die zusätzlich für eine In-Situ-Ätzratenkontrolle, zur Steuerung und Ätzendpunkterkennung auf dem Siliziumwafer angebracht ist. Hierzu ist auf dem Siliziumsubstrat 9 ein Bereich der Opferschicht 14 abgegrenzt und mit der zweiten Schicht 15 aus abgeschiedenem Polysilizium abgedeckt. Die Schicht 15 enthält Lochreihen 16, wobei die Löcher bis zur Opferschicht 14 durchgehen. Die Darstellung nach Fig. 4 zeigt einen Zustand in einem bereits fortgeschrittenen Ätzstadium, bei dem Ätzmedium in der Dampfphasenätzung durch die Lochreihen 16 zur Opferschicht 14 eingedrungen ist und jeweils unter einem Loch bereits eine wannenförmige Vertiefung 17 weggeätzt hat.

Auf das Siliziumsubstrat 9 und auf die zweite Schicht 15 sind Kontaktspitzen 18, 19 für eine Kapazitätsmessung aufgesetzt.

Nachfolgend wird die Funktion der In-Situ-Ätzratenkontrolle durch die Teststruktur in Verbindung mit Fig. 5 erläutert: Da die Ätzrate der Opferschicht durch externe Faktoren, wie Adsorption von Wasser an der Oberfläche beeinflußt werden, ist eine genaue Steuerung am günstigsten durch eine In-Situ-Kontrolle durchführbar. Da bei der erfindungsgemäßen Dampfphasenätzung das Ätzmedium elektrisch nicht leitet, kann im Gegensatz zum herkömmlichen Verfahren mit flüssigen Ätzmedien der Wafer elektrisch mit den Kontaktspitzen 18, 19 kontaktiert werden. Das Siliziumsubstrat 9 und die zweite Schicht 15 aus Polysilizium bilden die Kondensatorplatten eines Kondensators. Beim Start des Ätzvorgangs ist der Zwischenraum zwischen den Kondensatorplatten vollständig mit der Opferschicht als Dielektrikum ausgefüllt. Das Siliziumoxid der Opferschicht wird im Laufe des Ätzvorgangs zunehmend geätzt und durch Luft ersetzt, entsprechend der Darstellung in Fig. 5. Dadurch sinkt die effektive, relative Dielektrizitätskonstante von 3,85 ($C_{OX}$ für Siliziumoxid) auf 1 ($C_{Luft}$ für Luft). Der Ätzfortschritt kann somit an der Änderung des kapazitiven Signals, wie es über die Kontaktspitzen 18, 19 abgegriffen wird, verfolgt werden.

Bei konstanter Ätzrate nimmt bei üblichen Anordnungen die gemessene Kapazität zunächst mit einer quadratischen Zeitabhängigkeit ab und geht dann bei Überlappung von Ätzfronten in eine Sättigung über, so daß sich insgesamt der in Fig. 5 dargestellte, S-förmige Verlauf über die Zeitachse ergibt. Anreicherung und Verarmung von Wasser an der Oberfläche machen sich durch ein Abweichen von einer solchen S-förmigen Sollkurve bemerkbar und lassen sich in einem Regelkreis durch Änderung der Heizleistung der Heizung 5 kompensieren. Damit läßt sich der Ätzvorgang in einem sicheren Arbeitsbereich fahren, bei dem kritische Zustände, beispielsweise durch Bildung eines Wasserfilms auf der Oberfläche, verhindert werden.

Nach vollständiger Entfernung der Opferschicht 14 wird die Schicht 15 unter dem Druck der aufgesetzten Kontaktspitze 18 komprimiert und kommt dadurch zur Anlage am Siliziumsubstrat 9. Dies zeigt sich durch eine abrupte Erhöhung des Kapazitätssignals bzw. durch einen Kurzschluß, wie dies in Fig. 5 dargestellt ist. Dadurch wird der Endpunkt des Ätzvorgangs angegeben, entsprechend dem Pfeil 20. Eine solche In-Situ-Messung der Ätzrate ermöglicht die Vermeidung von Unter- und Überätzungen und von kritischen Arbeitsbereichen sowie die Regelung der Ätzrate in weiten Bereichen.

**Patentansprüche**

1. Verfahren zur Herstellung oberflächen-mikromechanischer Strukturen, wobei auf ein Siliziumsubstrat (9) eine Opferschicht (14) erzeugt wird, auf der Opferschicht (14) eine zweite Schicht (15) abgeschieden und strukturiert wird, die Opferschicht (14) in einem Ätzvorgang entfernt wird mit einem Ätzmedium, das die Opferschicht (14), jedoch nicht die zweite Schicht (15) angreift, wodurch Strukturen (7) entstehen, die in etwa im Abstand der Dicke der entfernten Opferschicht (14) frei über dem Siliziumsubstrat (9) stehen und an gewissen Stellen auf dem Siliziumsubstrat (9) verankert sind, wobei zur Freilegung der mikromechanischen Strukturen (7) das Siliziumsubstrat (9) der Dampfphase eines Gemisches aus Flußsäure (HF) und Wasser in einer Dampfphasenätzung ausgesetzt wird, dadurch gekennzeichnet, daß das Siliziumsubstrat (3, 9) während der Dampfphasenätzung beheizt (5) wird, um durch Steuerung des Wassergehalts auf der Oberfläche (4) des Siliziumsubstrats (3, 9) die Ätzrate auf einen bestimmten Wert einzustellen.

2. Verfahren nach Anspruch 1, dadurch gekennzeichnet, daß das Siliziumsubstrat (3, 9) bei der Dampfphasenätzung über einem Behälter (2) angeordnet ist, der eine azeotrope Flußsäurelösung (38,26 %) enthält und die Oberfläche (4) des Siliziumwafers (3) mit den freizulegenden Strukturen dem Behälterinnenraum zugewandt und der gesättigten Dampfphase ausgesetzt ist.

3. Verfahren nach einem der Ansprüche 1 bis 2, dadurch gekennzeichnet, daß eine Kondensation durch Pumpen verhindert wird.

4. Verfahren nach einem der Ansprüche 1 bis 3, dadurch gekennzeichnet, daß die zweite Schicht (15) aus Polysilizium und die Opferschicht (14) aus undotiertem Siliziumoxid besteht und diese mit der Dampfphasenätzung in der Dampfphase des Gemisches aus anhydrider Flußsäure und Wasser ohne anschließende Spülung und Trocknung entfernt wird.

5. Verfahren nach einem der Ansprüche 1 bis 4, dadurch gekennzeichnet, daß vor der Dampfphasenätzung zusätzliche, auf dem Siliziumsubstrat (3) angeordnete, elektronische Schaltungen zum Schutz vor dem Ätzmedium durch einen Schutzfilm aus Fotolack abgedeckt werden und dieser Schutzfilm nach der Dampfphasenätzung in einem Fotolackstripper mit Sauerstoffplasma entfernt wird.

6. Verfahren nach einem der Ansprüche 1 bis 5, dadurch gekennzeichnet, daß vor der Dampfphasenätzung Versteifungen (11) aus Fotolack als Brücken zwischen den freizulegenden Strukturen (7), insbesondere von großen Strukturen und dem Siliziumsubstrat (9), hergestellt werden, daß bei der Dampfphasenätzung durch Entfernung der Opferschicht die Strukturen (7) freigelegt und durch die ätzresistenteren Fotolack-Versteifungen (11) in ihrer Ausgangslage stabilisiert werden und daß nach der Dampfphasenätzung die Versteifungen (11) mit Sauerstoffplasma entfernt werden.

7. Verfahren nach einem der Ansprüche 1 bis 6, dadurch gekennzeichnet, daß zur Herstellung verkapselter Strukturen vor der Dampfphasenätzung Versteifungen (11) aus einem in der Dampfphase langsam und rückstandsfrei ätzenden Material, das zudem zu LPCVD-Depositionen (Low Pressure Chemical Vapor Deposition) kompatibel ist, als Brücken zwischen den freizulegenden Strukturen (7), insbesondere von großen Strukturen und dem Siliziumsubstrat (9), hergestellt werden, daß als Kapselung in einer LPCVD-Deposition eine weitere Schicht (12) mit Ätzöffnungen (13) zur freizulegenden Struktur angebracht ist, daß in einem ersten Ätzschritt mit der Dampfphasenätzung das Siliziumoxid der Opferschicht vollständig entfernt wird, wobei die langsam ätzenden Versteifungen (11) nur zum Teil angegriffen werden, daß in einem zweiten Ätzschritt durch Weiterätzen die Versteifungen (11) entfernt und die Struktur freigegeben wird und daß anschließend durch Deposition einer weiteren Schicht die Verkapselung verschlossen, das Siliziumsubstrat weiterbearbeitet und vereinzelt wird.

8. Verfahren nach Anspruch 7, dadurch gekennzeichnet, daß als temporäre Versteifungen (11) eine dünne Polysiliziumschicht verwendet wird, deren Ätzselektivität gegenüber der Opferschicht aus Siliziumoxid durch Sauerstoff implantation gezielt eingestellt wird.

9. Verfahren nach einem der Ansprüche 1 bis 8, dadurch gekennzeichnet, daß die Vereinzelung vor der Dampfphasenätzung erfolgt und die Dampfphasenätzung auf Chipebene durchgeführt wird.

10. Verfahren nach einem der Ansprüche 1 bis 9, dadurch gekennzeichnet, daß zusätzlich eine Teststruktur angebracht ist, bei der ein Bereich der zweiten Schicht (15) aus Polysilizium und das Siliziumsubstrat (9) als Kondensatorplatten mit dazwischenliegender Opferschicht (14) als Dielektrikum kontaktiert (18, 19) werden und daß während der Dampfphasenätzung beim Ersetzen der Opferschicht (14) durch Luft die effektive, relative Dielektrizitätskonstante sinkt und über ein entsprechendes, kapazitives Signal der Ätzfortschritt verfolgt und gegebenenfalls gesteuert wird.

11. Verfahren nach Anspruch 1, dadurch gekennzeichnet, daß auf der zweiten Schicht (15) eine Kontaktspitze (18) mit Druck aufgesetzt ist, die Teststruktur nach der Entfernung der Opferschicht (14) durch die Kontaktspitze (18) komprimiert wird, wodurch die zweite Schicht (15) am Siliziumsubstrat (9) anliegt und dadurch ein Kurzschluß bzw. eine abrupte Erhöhung des Kapazitätssignals erfolgt und damit ein Ende des Ätzvorgangs angegeben wird.

12. Verfahren nach einem der Ansprüche 1 bis 3, dadurch gekennzeichnet, daß die zweite Schicht aus Polysilizium und die Opferschicht aus dotiertem Siliziumoxid besteht, daß vor einem Ätzvorgang zur Entfernung der Opferschicht Versteifungen aus einem langsam ätzenden Material, insbesondere aus Polysilizium mit Sauerstoffimplantation, als Erücken zwischen den freizulegenden Strukturen und dem Siliziumsubstrat hergestellt werden, daß in einem ersten Ätzschritt in einer Flüssigphase eines Ätzmediums die Opferschicht vollständig entfernt wird, wobei die langsam ätzenden Versteifungen nur zum Teil angegriffen werden und ihre Versteifungsfunktion weiter erfüllen, daß das Siliziumsubstrat gespült und durch Schleudern getrocknet wird, wobei die Versteifungen die Strukturen in ihrer Lage halten und ein Anhaften auf der Substratoberfläche verhindern und daß in einem zweiten Ätzschritt mit Hilfe der Dampfphasenätzung die Versteifungen entfernt und dadurch die Strukturen freigegeben werden.

**Claims**

1. Method for fabricating surface-micromechanical structures which involves a sacrificial layer (14) being produced on a silicon substrate (9), a second layer (15) being deposited on the sacrificial layer (14) and being patterned, the sacrificial layer (14) being removed in an etching operation by means of an etching medium which attacks the sacrificial layer (14) but not the second layer (15), structures (7) being produced as a result which are free-standing above the silicon substrate (9) at a distance which is roughly equal to the thickness of the removed sacrificial layer (14) and are anchored at certain sites on the silicon substrate (9), for the purpose of exposing the micromechanical structures (7) the silicon substrate (9) being subjected to the vapour phase of a mixture of hydrofluoric acid (HF) and water in a vapour-phase etching process, characterized in that the silicon substrate (9) is heated (5) during the vapour-phase etching process, in order to adjust the etching rate to a specific value by controlling the water content on the surface (4) of the silicon substrate (9).

2. Method according to Claim 1, characterized in that the silicon substrate (9) in the course of the vapour-phase etching process is arranged above a vessel (2) which contains an azeotropic hydrofluoric acid solution (38.26%) and the surface (4) of the silicon wafer (3) containing the structures to be exposed faces the interior of the vessel and is exposed to the saturated vapour phase.

3. Method according to either of Claims 1 to 2, characterized in that condensation is prevented by pumping.

4. Method according to any one of Claims 1 to 3, characterized in that the second layer (15) consists of polysilicon and the sacrificial layer (14) consists of undoped silicon oxide and the latter is removed by means of the vapour-phase etching process in the vapour phase of the mixture of anhydrous hydrofluoric acid and water without subsequent rinsing and drying.

5. Method according to any one of Claims 1 to 4, characterized in that, prior to the vapour-phase etching process, additional electronic circuits disposed on the silicon substrate (9), in order to protect them from the etching medium, are covered by a protective film of photoresist and said protective film after the vapour-phase etching process is removed in a photoresist stripper by means of oxygen plasma.

6. Method according to any one of Claims 1 to 5, characterized in that, prior to the vapour-phase etching process, stiffeners (11) of photoresist are produced as bridges between the structures (7) to be exposed, in particular large structures, and the silicon substrate (9), in that, in the course of the vapour-phase etching process, the structures (7) are exposed by removal of the sacrificial layer and are stabilized in their initial position by the more etch-resistant photoresist stiffeners (11), and in that, after the vapour-phase etching process, the stiffeners (11) are removed by means of oxygen plasma.

7. Method according to any one of Claims 1 to 6, characterized in that, for the purpose of fabricating enclosed structures, prior to the vapour-phase etching process, stiffeners (11) of a material which etches slowly and without leaving any residues in the vapour phase and which is moreover compatible with LPCVD depositions (Low Pressure Chemical Vapour Deposition) are produced as bridges between the structures (7) to be exposed, in particular large structures, and the silicon substrate (9), in that, as an enclosure in the case of an LPCVD deposition, a further layer (12) is disposed which has etching orifices (13) towards the structure to be exposed, in that, in a first etching step, by means of the vapour-phase etching process, the silicon oxide of the sacrificial layer is removed completely, the slowly etching stiffeners (11) being attacked only in part, in that, in a second etching step, the stiffeners (11) are removed by continued etching and the structure is freed, and in that, subsequently, by deposition of a further layer, the enclosure is closed, the silicon substrate is subjected to further processing and is cut up.

8. Method according to Claim 7, characterized in that, as temporary stiffeners (11), a thin polysilicon layer is employed whose etching selectivity with respect to the sacrificial layer of silicon oxide is adjusted systematically by oxygen implantation.

9. Method according to any one of Claims 1 to 8, characterized in that the cutting-up process is carried out prior to vapour-phase etching and vapour-phase etching is carried out at the chip level.

10. Method according to any one of Claims 1 to 9, characterized in that a test structure is additionally disposed in which a region of the second layer (15), made of polysilicon, and the silicon substrate (9) as capacitor plates with a sacrificial layer (14) situated therebetween as the dielectric are made contact with (18, 19) and in that during the vapour-phase etching process, as the sacrificial layer (14) is replaced by air, the effective relative dielectric constant decreases, and the progress of etching is monitored via a corresponding capacitive signal and is controlled if required.

11. Method according to Claim 1, characterized in that a contact tip (18) is placed, with the application of pressure, on the second layer (15), the test structure after removal of the sacrificial layer (14) is compressed by the contact tip (18), which causes the second layer (15) to lie against the silicon substrate (9) and consequently a short circuit or an abrupt increase in the capacitance signal to occur and thus defines an end of the etching operation.

**12.** Method according to any one of Claims 1 to 3, characterized in that the second layer consists of polysilicon and the sacrificial layer consists of doped silicon oxide, in that, prior to an etching operation for removing the sacrificial layer, stiffeners made of a slowly etching material, in particular of polysilicon with implanted oxygen, are produced as bridges between the structures to be exposed and the silicon substrate, in that, in a first etching step in a liquid phase of an etching medium, the sacrificial layer is removed completely, the slowly etching stiffeners being attacked only in part and continuing to fulfil their stiffening function, in that the silicon substrate is rinsed and is dried by spinning, the stiffeners retaining the structures in their position and preventing adhesion to the substrate surface, and in that, in a second etching step with the aid of vapour-phase etching, the stiffeners are removed and as a result the structures are freed.

**Revendications**

**1.** Procédé de fabrication de structures de surface micromécaniques selon lequel :

- on réalise une couche sacrifiée (14) sur un substrat (support) de silicium (9),
- on dépose une seconde couche (15) sur la couche sacrifiée (14) et on structure cette couche,
- on enlève la couche sacrifiée (14) par une opération d'attaque chimique avec un agent d'attaque chimique qui attaque la couche sacrifiée (14) mais non la seconde couche (15) en formant ainsi les structures (7) qui sont en porte-à-faux par rapport au substrat de silicium (9) sensiblement d'une distance correspondant à l'épaisseur de la couche sacrifiée (14), qui a été enlevée, et ces structures sont accrochées en certains endroits au substrat de silicium (9),
- et pour dégager les structures micromécaniques (7), on expose le substrat de silicium (9) à la phase vapeur d'un mélange d'acide fluorhydrique (HF) et d'eau dans une attaque chimique en phase vapeur,

caractérisé en ce que
pendant l'attaque chimique en phase vapeur, on chauffe (5) le substrat (9) de silicium pour régler par commande de la teneur en eau à la surface (4) du substrat de silicium (3, 9), la vitesse d'attaque chimique sur une certaine valeur déterminée.

**2.** Procédé selon la revendication 1,

caractérisé en ce que
le substrat de silicium (3, 9) est placé au-dessus d'un récipient (2) pour l'attaque chimique en phase vapeur, ce récipient contenant une solution d'acide fluorhydrique azéotrope (38, 26 %) et la surface (4) de la plaquette de silicium (3) avec les structures à dégager est tournée l'intérieur du récipient pour être exposée à la phase vapeur.

**3.** Procédé selon l'une des revendications 1 et 2, caractérisé en ce qu'
on pompe pour éviter la condensation.

**4.** Procédé selon l'une quelconque des revendications 1 à 3,
caractérisé en ce que
la seconde couche (15) est en polysilicium et la couche sacrifiée (14) en oxyde de silicium non dopé et celle-ci est enlevée par l'attaque chimique en phase vapeur dans la phase vapeur du mélange d'acide fluorhydrique anhydre et d'eau, non suivie de rinçage et de séchage.

**5.** Procédé selon l'une des revendications 1 à 4, caractérisé en ce qu'
avant l'attaque chimique en phase vapeur, on recouvre en outre les circuits électroniques prévus sur le substrat en silicium (3) pour les protéger contre l'agent d'attaque chimique, à l'aide d'un film protecteur de photorésist et on enlève ce film protecteur après l'attaque chimique en phase vapeur dans une étape d'enlèvement de photorésist avec du plasma à l'oxygène.

**6.** Procédé selon l'une des revendications 1 à 5, caractérisé en ce qu'
avant l'attaque chimique en phase vapeur, on réalise des renforcements (11) en photorésist constituant des ponts entre les structures à dégager (7) notamment des structures de grande dimension et le substrat de silicium (9), et lors de l'attaque chimique en phase vapeur, on dégage les structures (7) par enlèvement de la couche sacrifiée et on stabilise par les renforcements (11) de photorésist, qui résistent à l'attaque chimique dans leur position de sortie et en ce qu'après l'attaque chimique en phase vapeur, on enlève les renforcements (11) avec du plasma d'oxygène.

**7.** Procédé selon l'une des revendications 1 à 6, caractérisé en ce que

- pour réaliser les structures encapsulées, avant l'attaque chimique en phase vapeur, on réalise en une matière à caractéristiques d'attaque chimique lente en phase vapeur et sans laisser de résidus, compatible avec des dépôts LPCVD (dépôt chimique à la vapeur basse pression), des ponts entre les structures à dégager (7) notamment des grandes structures et le substrat de silicium (9),

- on réalise comme encapsulage par un dépôt LPCVD, une autre couche (12) avec des orifices d'attaque chimique (13) vers la structure à dégager,

- dans une première étape d'attaque chimique en phase vapeur, on enlève complètement l'oxyde de silicium de la couche sacrifiée, alors que les renforcements (11) d'attaque chimique plus lente ne sont attaqués qu'en partie,

- dans une seconde étape d'attaque, en poursuivant l'attaque chimique, on enlève les renforcements (11) et on dégage la structure et,

- puis par dépôt d'une autre couche, on ferme l'encapsulage, on poursuit le traitement du substrat de silicium et on divise.

8. Procédé selon la revendication 7, caractérisé en ce que comme renforcements (11), provisoires, on utilise une mince couche de polysilicium dont la sélectivité vis-à-vis de l'attaque chimique est réglée par rapport à celle de la couche sacrifiée d'oxyde de silicium, par implantation d'oxygène.

9. Procédé selon l'une des revendications 1 à 8, caractérisé en ce qu' on réalise la division avant l'attaque chimique en phase vapeur et on effectue cette attaque au niveau des plaquettes.

10. Procédé selon l'une des revendications 1 à 9, caractérisé en ce qu'

- on applique en outre une structure de test pour laquelle on utilise une zone de la seconde couche (15) de polysilicium et le substrat de silicium (9) comme plaques d'un condensateur séparées par la couche sacrifiée (14) constituant le diélectrique, en mettant en contact (18, 19) et,

- pendant l'attaque chimique en phase vapeur, lorsque la couche sacrifiée (14) est remplacée par l'air, la constante diélectrique relative, efficace diminue et le signal capacitif correspondant permet de suivre la progression de l'attaque chimique et le cas échéant de la commander.

11. Procédé selon la revendication 1, caractérisé en ce que

- sur la seconde couche (15), on applique une pointe de contact (18) sous pression,

- on comprime la structure d'essai après enlèvement de la couche sacrifiée (14) avec la pointe de contact (18) pour que la seconde couche (15) vienne s'appuyer contre le support de silicium (9) et produise un court-circuit ou une augmentation brusque du signal de la capacité, indiquant ainsi la fin de l'opération d'attaque chimique.

12. Procédé selon l'une des revendications 1 à 3, caractérisé en ce que

- la seconde couche est du polysilicium et la couche sacrifiée de l'oxyde de silicium dopé,

- avant l'opération d'attaque chimique pour enlever la couche sacrifiée, on réalise des renforcements en une matière à corrosion lente notamment en polysilicium avec implantation d'oxygène comme des ponts entre les structures à dégager et le substrat de silicium,

- dans une première étape d'attaque chimique, on enlève complètement la couche sacrifiée avec un agent d'attaque chimique en phase liquide, les renforcements d'attaque lente n'étant attaqués qu'en partie et conservant leur fonction de renforcement,

- on rince le substrat de silicium et on le sèche par centrifugation, les renforcements maintenant les structures en place et évitant l'accrochage à la surface du substrat et,

- dans une seconde étape d'attaque chimique par une attaque chimique en phase vapeur, on enlève les renforcements et on dégage ainsi les structures.

FIG. 1

FIG . 2

FIG. 3

FIG.4

FIG.5